Europäisches Patentamt

European Patent Office (11) Veröffentlichungsnummer: **0 073 904**
**B1**

Office européen des brevets

(19)

## (12) EUROPÄISCHE PATENTSCHRIFT

(45) Veröffentlichungstag der Patentschrift:
**03.06.87**

(51) Int. Cl.⁴: **H 05 K 3/20,** H 01 C 17/06,
H 05 K 3/10, H 05 K 3/12

(21) Anmeldenummer: **82106288.2**

(22) Anmeldetag: **14.07.82**

(54) **Verfahren zur Herstellung von gedruckten Schaltungen.**

(30) Priorität: **08.09.81 DE 3135554**

(43) Veröffentlichungstag der Anmeldung:
**16.03.83 Patentblatt 83/11**

(45) Bekanntmachung des Hinweises auf die Patenterteilung:
**03.06.87 Patentblatt 87/23**

(84) Benannte Vertragsstaaten:
**AT BE CH FR GB LI NL**

(56) Entgegenhaltungen:
**CH - A - 328 577**
**DE - B - 1 100 741**
**DE - B - 1 106 822**
**GB - A - 999 183**
**US - A - 3 909 680**

(73) Patentinhaber: **PREH, Elektrofeinmechanische Werke Jakob Preh Nachf. GmbH & Co.,**
**Postfach 1740 Schweinfurter Strasse 5, D-8740 Bad Neustadt/Saale (DE)**

(72) Erfinder: **Ambros, Peter, Dipl.-Chem., Am Wacholderrain 12, D-8741 Hohenroth/Leutershausen (DE)**
Erfinder: **Budig, Walter, Buchenweg 1, D-8741 Wülfershausen (DE)**

**Beschreibung**

Die Erfindung betrifft ein Verfahren zur Herstellung von gedruckten Schaltungen mit in diese integrierten elektrischen Widerständen, Potentiometerbahnen, Schaltkontaktstellen oder Kodierschaltanordnungen gemäss dem Oberbegriff des Anspruchs 1 und wie aus der US-A-3 909 680 bekannt ist.

Gedruckte Schaltungen sind in vielfältigen Ausführungen bekannt. Im Prinzip bestehen sie aus einer Basis- oder Trägerplatte aus einem elektrisch isolierenden Material, auf welcher Leiterbahnen aus einem elektrisch leitenden metallischen Material gemäss einem entsprechend der jeweiligen Schaltungskonfiguration ausgebildeten Leitungsmuster aufgebracht sind; ggf. können – bei Ausbildung als sogenannte Multi-Layer-Anordnung – auch mehrere Leitungsmuster übereinander in verschiedenen Ebenen angeordnet sein, wobei die verschiedenen Schaltungsebenen durch elektrisch leitende Durchkontaktierungen elektrisch-funktionell miteinander verbunden sind.

Als Basis- oder Trägermaterial dient üblicherweise ein vorzugsweise faserverstärkter Schichtpressstoff oder sogenanntes Hartpapier oder ggf. auch eine Kunststoff-Folie. Die Herstellung der Leitungsmuster erfolgt zumeist im sogenannten Subtraktivverfahren in der Weise, dass das Basis- bzw. Trägermaterial ganzflächig mit einer dünnen Metallfolie, zumeist Kupferfolie, kaschiert ist und aus dieser Metallage durch selektive Abtragung beispielsweise durch selektive Ätzung unter Verwendung einer Positiv-Abdeckmaske aus einem Ätz-Resist-Material, die Leiterbahnen gemäss dem der gewünschten Schaltung entsprechenden Lay-out erzeugt werden. Alternativ kann die Ausbildung des Leitermusters auch im sogenannten additiven Verfahren unter Verwendung einer Negativ-Abdeckmaske erfolgen, bei welcher die dem gewünschten Leitungsmuster entsprechenden Teile der Substratoberfläche unabgedeckt bleiben und in diesen Bereichen ein metallisches Leitermaterial abgeschieden wird, beispielsweise durch galvanische Abscheidung oder aber auch aus einem stromlos arbeitenden Bad.

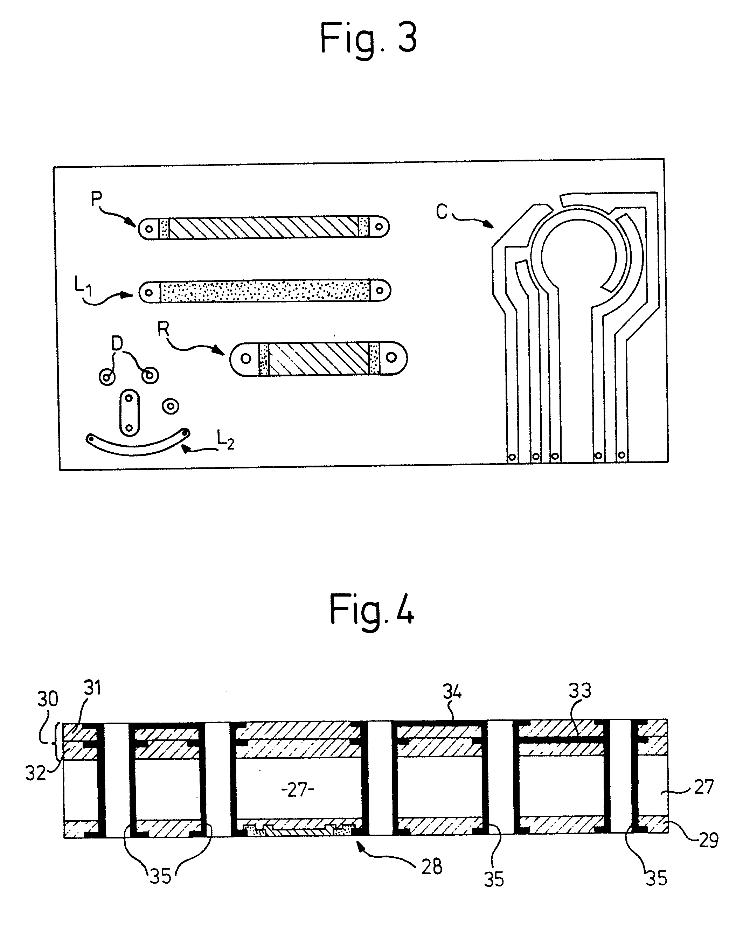

Durch die neuere technische Entwicklung insbesondere im Zusammenhang mit der zunehmenden Bedeutung von Ein- und Ausgabeelementen oder Anzeigen, beispielsweise in Form von Kodier- und Dekodier-Schaltungen mit Eingabetastaturen von Rechnern oder dergleichen, besteht ein zunehmendes Bedürfnis nach gedruckten Schaltungen, welche in die Leitungsmuster integrierte Widerstandsnetzwerke, Schaltkontaktstellen oder Kodierschaltungsanordnungen integriert enthalten. Unter Schaltkontaktstellen sind dabei mit in die Leiterbahnkonfiguration einbezogenen Festkontakten ausgebildete Unterbrechungen der Leiterbahnen zu verstehen, welche durch mit den Festkontakten zusammenwirkende bewegliche Kontakte, die beispielsweise als Federkontakte oder bevorzugt als Gummimattenkontakte ausgebildet sein können, überbrückbar sind. Unter Kodierschaltern sind ebenfalls in die Leitungsmuster integrierte Anordnungen von Kodierschaltersegmenten zu verstehen, welche mit äusseren beweglichen Kontaktorganen zusammenwirken, wie beispielsweise bei C in Figur 3 der Zeichnung angedeutet.

Nach dem Stande der Technik sind bereits verschiedene Versuche zur Integration von Widerständen und ggf. auch von Schaltkontaktstellen in die im Subtraktivverfahren hergestellten elektrischen Leitungsmuster gedruckter Schaltungen bekannt geworden. Hierbei werden in die fertig ausgebildeten, in der erwähnten Weise durch selektive Ätzung mittels Positiv-Abdeckmasken erzeugten elektrischen Schaltungen Widerstandspasten gemäss dem für die Widerstände und ggf. Schaltkontaktstellen gewünschten Lay-out eingedruckt, vorzugsweise im Siebdruckverfahren. Die Widerstands-Siebdruckpasten bestehen dabei im wesentlichen aus einem organischen polymeren Bindemittel, in das teilchenförmiger Kohlenstoff wie beispielsweise Russ oder Graphitteilchen eindispergiert sind, welche die elektrisch leitfähige Komponente des Systems bilden und gleichzeitig als Ätzresist bei einer Herstellung der erforderlichen Schaltung aus dem kupferkaschierten Material dient. Dieses bekannte Verfahren des Aufdruckens von Widerstandspasten an die auszuätzenden Kupfer-Leiterbahnen der jeweiligen gedruckten Schaltung ermöglicht auch die Ausbildung von Schaltkontaktstellen in der Weise, dass eine als Ätzresist eingesetzte kohlenstoffhaltige Siebdruckpaste der vorstehend genannten Art relativ hoher Leitfähigkeit sich an den Kupferleiterbereichen der einzelnen Schaltstellenkontakte befindet, wobei diese Schaltstellenkontakte durch die Russ- bzw. Graphit-Pastenabdeckung ohne die ansonsten erforderliche oberflächige Vernikkelung und Vergoldung oder Versilberung die für derartige Schaltkontaktstellen erforderliche Oxydationsbeständigkeit erhalten, vgl. rme radiomento electronic, Nov. 1980, Heft 11, S. 313–315.

Die für das Eindrucken der Widerstände bzw. für die Pastenbedruckung der Schaltkontaktstellen verwendeten Widerstandspasten benötigen eine thermische Fixierung zur sowohl mechanischen wie auch elektrischen Stabilisierung durch eine Wärmebehandlung bei verhältnismässig hohen Temperaturen. Hieraus haben sich eine Reihe von Nachteilen bei diesem bekannten Verfahren mit nachträglichem Eindruck von Widerstandsbereichen in Leiterbahnkonfigurationen von Leiterplatten, die beispielsweise in subtraktiver Ätztechnik aus mit Kupfer kaschierten Substratplatten hergestellt wurden, ergeben. Die zu einer guten Fixierung der elektrischen Stabilität der Widerstandsschichten erforderliche Temperatur hat eine erhöhte Oxydation der Kupferleiterbahnen zur Folge und beeinträchtigt deren Haftung am Basis- oder Trägermaterial durch eine Wärmedegradation des Haftklebers der Kupferkaschierung. Die unterschiedliche Wärmeausdehnung der Kupferbahnen und der dazwischenliegenden Widerstandsschichten hat darüberhinaus eine erhöhte Tendenz zur Rissbildung der Widerstandsschicht an den Übergängen zwischen den Kupferleiterbahnen und den Widerständen zur Folge, was dann zu elektrischen Leitungsunterbrechungen führen kann. Die thermische Belastung durch die zu einer guten elektrischen Stabilisierung der Polymer-Widerstandsschichten erforderliche relativ hohe Aushärttemperatur würde ferner durch eine Versprödung des Hartpapier-Basismaterials dessen mechanische Eigenschaften drastisch beeinträchtigen. Infolge einer partiellen Verkohlung würde sich auch der Oberflächenisolationswiderstand des Hartpapier-Basismaterials verringern. Des weiteren hätte die zur ausreichenden Stabilisierung der Widerstandsschichten erforderliche relativ hohe Aushärttemperatur eine Erhöhung des Übergangswiderstands der Schaltkontaktstellen infolge einer partiellen Umwandlung des unter der Kontaktstelle liegenden Kupfers in ein elektrisch isolierendes Kupferoxyd zur Folge. Verzichtet man infolge der durch die Wärmebehandlung verursachten Schwierigkeiten auf eine ausreichende thermische Fixierung bzw. beschränkt man die Wärmebehandlung auf verhältnismässig niedrige Aushärttemperaturen, so ist keine optimale elektrische Stabilität der so erhaltenen Schaltung mit integrierten Widerständen erzielbar.

Ein anderes bekanntes Verfahren zur Integrierung von Widerständen in Leiterplatten geht von der Verwendung eines Substratmaterials aus, das mit einer metallischen Widerstandsschicht, zum Beispiel aus einer Cr/Ni-Legierung und einer darüberliegenden Kupferschicht kaschiert ist; in einem derartigen doppelt kaschierten Substratmaterial werden sodann die Leiterbahnen und die Widerstandsbereiche einer elektrischen Schaltung in subtraktiver Technik durch eine Differentialätzung realisiert, vgl. «Bauteile-Report», 16 (1978), Heft 3, S. 91–93, sowie Aufsatz von Horst W. Scheidt «Widerstände drucken mit Omega-Material» in Sonderdruck aus «Elektronik Packaging & Produktion», November 1976. Diese bekannte Technik hat zum einen den Nachteil, dass ein verhältnismässig kostspieliges doppellagig kaschiertes Substratmaterial benötigt wird, und dass zum anderen die Widerstandsvariierung überwiegend nur über die Geometrie der Widerstandsbereiche möglich ist, was schon aus Abmessungsgründen der Variation enge Grenzen setzt und insbesondere bei Schaltungen, für die eine höhere Packungsdichte gefordert wird, Schwierigkeiten bereitet.

Der Erfindung liegt als Aufgabe die Schaffung eines Verfahrens zugrunde, das ausgehend von einfachem, billigem unkaschiertem Substratmaterial, die Herstellung von gedruckten Schaltungen mit in das Leitungsmuster integrierten Widerständen, Potentiometerbahnen, Schaltkontaktstellen oder Kodierschaltanordnungen gestattet, und bei dem einerseits eine optimale mechanische und elektrische Stabilisierung der für die Herstellung der erwähnten integrierten passiven Schaltungsteile verwendeten Widerstandsschichten durch Anwendung ausreichend hoher Aushärttemperaturen gewährleistet ist und andererseits eine Beeinträchtigung des als Schaltungsträger dienenden isolierenden Hartpapiermaterials durch Versprödung und oberflächige Verzunderung vermieden und gute mechanische und Oberflächenisolations-Eigenschaften des Hartpapier-Basismaterials, eine gute Haftung der Leiterbahnen an der gedruckten Schaltung und ein niedriger Übergangswiderstand der Schaltkontaktstellen gewährleistet bleibt und eine Oxydation der Kupferleiterbahnen und die Tendenz zur Rissbildung an den Übergängen zwischen den Widerstandsschichten und den Leiterbahnen zuverlässig vermieden wird.

Zu diesem Zweck kennzeichnet sich ein Verfahren der eingangs genannten Art gemäss der Erfindung durch die Verfahrensschritte gemäss dem Kennzeichnungsteil des Anspruchs 1.

Durch die Erfindung wird in einfacher Weise die Integration passiver Bauteile wie Widerstände, Potentiometerbahnen, Schaltkontaktstellen oder Kodierschaltanordnungen in gedruckte Schaltungen ermöglicht, wobei durch den anfänglichen Aufbau der Schaltung auf einer als vorläufiger Träger dienenden Metallschicht mit späterer Umkehr-Laminierung dieses vorläufigen Schaltungsträgers auf eine als permanenter Schaltungsträger dienende Isolierstoff-, insbesondere Hartpapier- Platte, die für eine gute elektrische Stabilität der Polymer-Widerstands- bzw. Leitfähigkeitsschichten erforderliche Aushärtung bei hoher Aushärttemperatur vor der Umlaminierung auf das elektrisch isolierende Hartpapier- Basismaterial vorgenommen werden kann, wodurch eine Beeinträchtigung des als permanenter Träger dienenden Basismaterials und der Haftung der Schaltungsteile an diesem und der übrigen erwähnten Beeinträchtigungen durch die hohe Aushärttemperatur zuverlässig vermieden wird.

Gemäss einer vorteilhaften Ausgestaltung der Erfindung kann dabei in der Weise vorgegangen werden, dass die Leiterbahnen und ggf. die Kodierschaltersegmente auf der mit dem Widerstandsmaterial-Lay-out versehenen Oberfläche der Metallschicht vor der Umkehr-Laminierung unter Verwendung einer Negativ-Abdeckmaskierung additiv aufgebaut werden, und dass die Metallschicht im abschliessenden Verfahrensschritt nach der Umkehr-Laminierung vollständig entfernt wird, wobei der additive Aufbau der Leiterbahnen (und ggf. der Kodierschaltersegmente) vorzugsweise durch galvanische Abscheidung, alternativ aber auch stromlos erfolgen kann, und zwar ggf. in mehreren übereinander liegenden Schichten aus unterschiedlichen Metallen. Diese vorteilhafte Ausführungsform der vorliegenden Erfindung eignet sich bevorzugt zur Herstellung von Schaltungen mit integrierten Potentiometerbahnen (für Dreh- oder Schieberegler) und/oder integrierten Kodierschaltanordnungen, da hierbei die nach der vollständigen Entfernung der ursprünglichen Metallschicht erhaltene endgültige gedruckte Schaltung eine vollkommen glattebene, stufenfreie Schaltungsoberfläche aufweist, in welcher die Leiterbahnen und die verschiedenen integrierten passiven Bestandteile auf einheitlichem Niveau an der Oberfläche freiliegen und somit eine stufenlose Überfahrbarkeit durch Potentiometerschleifabgriffe bzw. durch die beweglichen Kodierschaltkontakte möglich ist.

Gemäss einer anderen, besonders einfachen Ausführungsform der Erfindung mit Ausbildung der Leiterbahnen im Subtraktivverfahren ist vorgesehen, dass die als vorläufige Trägerschicht dienende Metallschicht aus einem Metall, insbesondere aus Kupfer besteht, und dass die Leiterbahnen nach der Umkehr-Laminierung als abschliessender Verfahrensschritt unter Verwendung einer Positiv-Abdeckmaskierung in subtraktiver Technik aus der anfänglichen Metallschicht durch selektive Ätzung erzeugt werden. Wegen der hierbei an der nach der selektiven Abätzung der anfänglichen Metallschicht an der Oberfläche der fertigen gedruckten Schaltung verbleibenden Stufen zwischen den Leiterbahnen und den in das Leitungsmuster integrierten passiven Schaltungselementen eignet sich diese Ausführungsform nur bedingt zur Integration von Potentiometern und Kodierschaltanordnungen.

Bei dem erfindungsgemässen Verfahren besteht praktisch keine Einschränkung hinsichtlich Temperatur und Dauer der zur Aushärtung der Widerstandsschichten angewandten Wärmebehandlung; diese kann vorzugsweise bei einer relativ hohen Temperatur im Bereich von 180–250 °C erfolgen, bei welcher eine optimale mechanische und elektrische Fixierung und Stabilisierung der Widerstandsschichten gewährleistet ist.

Zur Herstellung der für die passiven integrierten Bauteile verwendeten Widerstandsschichten finden vorzugsweise Widerstands- bzw. Leitfähigkeitspasten Anwendung, welche aus einem organischen Polymer-Bindemittel mit in diesem eindispergierten elektrisch leitenden Teilchen aus einem Material der Gruppe: Russ, Graphit, Pyropolymer, Gold, Silber, Nickel oder versilberte Kupferteilchen mit einer Korngrösse von kleiner als 10 μ bestehen. Die Aufbringung der Widerstands- bzw. Polymer-Leitfähigkeitspaste kann vorzugsweise im Siebdruck- oder Spritzverfahren aufgebracht werden. Dabei ist nach dem erfindungsgemässen Verfahren ggf. die Anwendung verschiedener Widerstands- bzw. Leitfähigkeitspasten unterschiedlicher elektrischer Leitfähigkeit durch aufeinanderfolgende Bedruckungen möglich, wodurch ein breiter Variationsbereich der Widerstandswerte bei weitgehend einheitlicher Geometrie verfügbar wird und eine hohe geometrische Packungsdichte eingehalten werden kann.

Die für die Erzeugung des Leiterbahnen-Layouts verwendeten positiven oder negativen Abdeckmaskierungen können je nach der Struktur des gewünschten Leiterbahnen-Lay-outs im Siebdruckverfahren oder unter Anwendung photolithographischer Verfahren erzeugt werden.

Das erfindungsgemässe Verfahren eignet sich in weiterer Ausbildung auch zur Erzeugung von gedruckten Schaltungen auf beiden Seiten der als permanenter Träger dienenden Isolierstoffplatte, ggf. auch in Ausbildung als Multi-Layer-Anordnung, mit entsprechenden Durchkontaktierungen zur Verbindung der Schaltungen auf den beiden Seiten der Isolierstoffplatte und/oder in den verschiedenen Schaltungsebenen der Multi-Layer-Anordnung.

Im Folgenden werden Ausführungsbeispiele der Erfindung anhand der Zeichnungen beschrieben; in dieser zeigen

Figur 1 in den verschiedenen Stadien im Verlauf der Herstellung entsprechenden Teilfiguren 1a–1h die Herstellung einer gedruckten Schaltung mit integrierten passiven Elementen, gemäss einer ersten vorteilhaften Ausführungsform der Erfindung

Figur 2 in ebenfalls verschiedenen Stadien im Verlauf der Herstellung entsprechenden Teilfiguren 2a–2g die Herstellung einer gedruckten Schaltung mit integrierten passiven Elementen gemäss einer anderen Ausführungsform der Erfindung

Figur 3 in schematisierter Draufsicht einen Teilbereich einer erfindungsgemässen Schaltung mit den verschiedenen Schaltungsteilen (Leiterbahnen, Potentiometerbahnen, Festwiderstände, Kodierschaltanordnungen)

Figur 4 eine erfindungsgemäss hergestellte Schaltungsanordnung mit auf beiden Oberflächen der als permanenter Schaltungsträger dienenden Isolierstoffplatte vorgesehene Schaltungen, auf einer Oberfläche in Ausbildung als Multi-Layer-Anordnung, mit Durchkontaktierungen zur elektrisch-funktionellen Verbindung der verschiedenen Schaltungsebenen.

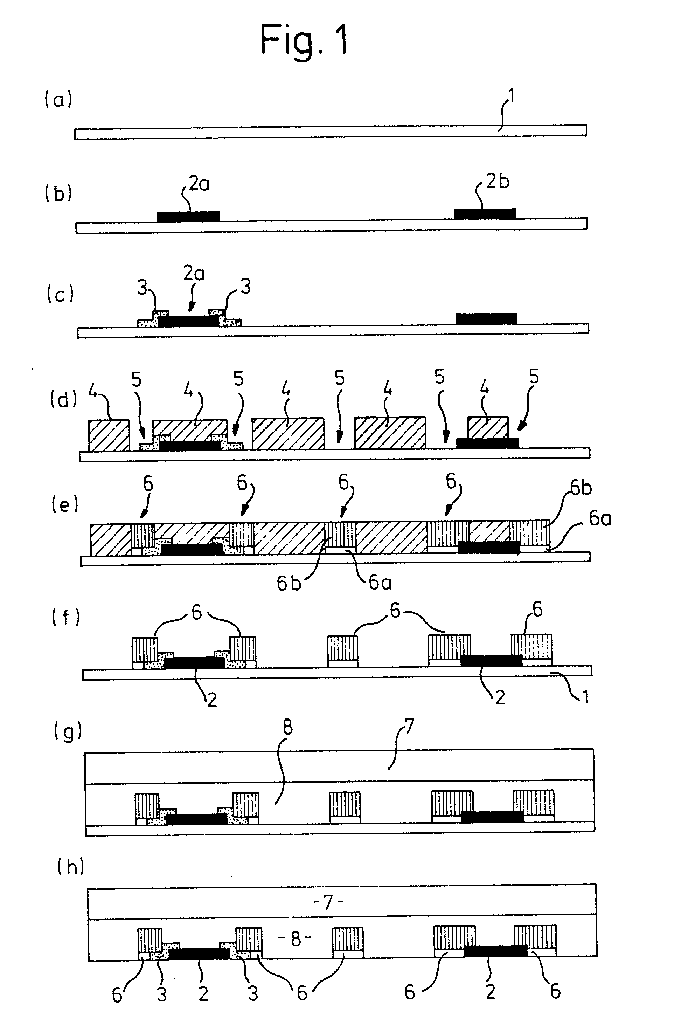

Im Folgenden wird anhand von Fig. 1 die Herstellung einer gedruckten Schaltung gemäss einer vorteilhaften Ausführungsform der Erfindung beschrieben, die sich bevorzugt zur Anwendung in solchen Fällen eignet, wo in das Leitungsmuster der Schaltung Kodierschalter integriert sind, da die nachfolgend beschriebene bevorzugte Ausführungsform der Erfindung eine völlig glattebene, niveau-gleiche Schaltungsoberfläche ohne Stufen ergibt, wie dies für Anwendungsfälle mit integrierten Kodierschaltern erforderlich ist.

Ausgehend von einer Aluminium- oder auch Kupferfolie 1 (Fig. 1a) von beispielsweise 40 μm Schichtstärke wird gemäss Fig. 1b in einem ersten Verfahrensschritt im Siebdruckverfahren aus einer oder ggf. auch mehreren Widerstandspasten geeigneter spezifischer elektrischer Leitfähigkeit ein Muster gemäss dem für die in die elektrische Schaltung zu integrierenden Widerständen, Potentiometerbahnen bzw. Schaltkontaktstellen gewünschten Lay-out aufgedruckt; in Fig. 1b sind Teile dieses Lay-outs bei 2a, 2b dargestellt, bei denen es sich also um Abschnitte von Widerständen, Potentiometerbahnen (Dreh- oder Schieberegler) bzw. von Schaltkontaktstellen handeln kann. Bei den Siebdruckpasten handelt es sich in der erwähnten Weise um ein organisches Bindemittel-Polymermaterial mit eindispergierten elektrisch leitfähigem Russ-, Graphit-, Pyropolymer-, Gold-, Silber-, Nickel- oder versilberten Kupferteilchen. Gemäss Fig. 1c können dabei bestimmte Teile dieser Leitfähigkeitspastenbedruckung 2 in den Anschlussbereichen mit einer überlappenden Silberleitfähigkeitspaste 3 bedruckt werden, wie in Fig. 1c für den Lay-out-Bereich 2a angedeutet; hierbei kann es sich beispielsweise um die Schleiferanschlussstellen $P_a$ der Potentiometerbahnen P gemäss Fig. 3 oder entsprechend um die Festwiderstandsanschlussstellen $R_a$ der Festwiderstandsbereiche R (in Fig. 3) handeln.

Nach Antrocknung der Bedruckungen 2 und ggf. 3 als vorläufiger Fixierung folgt nun gemäss Fig. 1d eine Negativabdeckung des gesamten Substrats als Vorbereitung für den additiven Aufbau des Leitungsmusters der Schaltung einschliesslich eventueller in die Schaltung zu integrierender Kodierschaltersegmente nach Art der Segmente C in Fig. 3. Falls dieser Aufbau des Leitungsmusters galvanisch erfolgt, dient als Abdeckung ein Galvanoresist-Lack 4, der in der erwähnten Weise als Negativmaske aufgedruckt wird, d.h. es werden alle diejenigen Bereiche des Substrats abgedeckt, in welchen keine Leiterbahnen bzw. Kodierschaltersegmente aufgebaut werden sollen.

Vor oder vorzugsweise nach dieser Negativabdeckung wird sodann das ganze System bei Temperaturen im Bereich von 200–250 °C ausgehärtet.

In einem nun folgenden dritten Verfahrensschritt werden in den freiliegenden, nicht mit dem Material 4 abgedeckten Bereichen 5 metallische Leiterschichten gemäss dem für die gedruckte Schaltung gewünschten Leitungsmuster einschliesslich der eventuell in dieses zu integrierenden Kodierschaltersegmente durch Abscheidung aufgebaut. Im beschriebenen Ausführungsbeispiel erfolgt die Abscheidung galvanisch, und zwar vorzugsweise mehrschichtig; in Fig. 1e sind der Übersichtlichkeit halber zwei übereinanderliegende metallische Leiterschichten 6a, 6b in den für die Leiterpfade vorgesehenen Bereichen 5 angedeutet. Als Leitermetall-Kombinationen kommen beispielsweise in Frage: Eine Gold-, Nickel- und Kupferschicht; eine Zinn- und Kupferschicht; oder eine Zinn/Bleilegierungs-Schicht und Kupferschicht. Die in diesem Verfahrensschritt aufgebauten Leiterbahnen 6 bilden nunmehr die gewünschte Schaltung mit den in die Schaltung integrierten passiven elektrischen Bauteilen 2 (Widerstände, Potentiometerbahnen, Schaltkontaktstellen, Kodierschalter), die zuvor erzeugt und ausgehärtet worden waren. Die Reihenfolge der Abscheidungen kann auch in umgekehrter Weise erfolgen.

Gemäss Fig. 1f wird sodann das Abdeckermaterial 4 von dem so erhaltenen Gebilde entfernt.

In einem folgenden Verfahrensschritt wird nunmehr die Aluminiumplatte 1 mit ihrer die bisher beschriebene ausgebildete elektrische Schaltung tragenden Seite auf ein als bleibende Trägerplatte 7 dienendes elektrisches Isoliermaterial, vorzugsweise Hartpapier, auflaminiert, und zwar vorzugsweise unter Verwendung eines Epoxydharzklebers 8. Dieses Laminierverfahren ist beispielsweise aus der Herstellung von Kupfer-kaschierten Laminaten an sich bekannt.

Im folgenden abschliessenden Verfahrensschritt gemäss Fig. 1h wird nunmehr von dem so erhaltenen Laminat die als vorläufiger anfänglicher Träger während des Herstellungsverfahrens dienende Aluminium- (oder Kupfer-) Schicht 1 vollständig abgeätzt, beispielsweise unter Verwendung eines alkalischen Ätzmittels, das lediglich die Aluminiumplatte abträgt. Auf diese Weise erhält man so das Gebilde gemäss Fig. 1h, welches auf der als dauerhafte Trägerplatte dienenden Isolierplatte 7 eingebettet in den Epoxydharzkleber 8 nunmehr die zuvor auf der ursprünglichen Aluminiumschicht erzeugte Schaltung (Leiterbahnen 6 mit in das Leitungsmuster integrierten Widerständen, Potentiometern, Schaltkontaktstellen, Kodierschaltern usw. aus dem Material 2) aufweist.

Dabei weist diese als endgültiges Gebilde erhaltene gedruckte Schaltung gemäss Fig. 1h eine vollkommen glatt-ebene, stufenfreie Schaltungsoberfläche (Unterseite in Fig. 1h) auf, in welcher die aus der bzw. den Widerstandspaste(n) gebildeten Bereiche 2 (Festwiderstände, Potentiometerbahnen, Schaltkontaktstellen, Kodierschaltersegmente), ggf. deren versilberte Anschlusskontaktstellen 3 sowie die Leiterbahnen 6 auf einheitlichem Niveau in dem als Einbettung dienenden Epoxydharzmaterial 8 an der Oberfläche freiliegen. Diese Ausführungsform eignet sich daher besonders vorteilhaft zur Anwendung in Fällen, in welchen in die gedruckte Schaltung Potentiometer (Schiebe- oder Drehregler) und insbesondere Kodierschaltersegmente integriert werden sollen, für welche eine stufenlose Überfahrbarkeit durch die Potentiometerabgriffe bzw. die beweglichen Kodierschalterkontakte erforderlich ist.

Fig. 3 veranschaulicht in vereinfachter schematisierter Darstellung in Draufsicht eine derartige Schaltung, mit einer Potentiometerbahn P, einer Leiterbahn L1 aus Silberpaste, einer Leiterbahn $L_2$ aus Kupfer, einem Festwiderstand R, Kodierschaltersegmenten C sowie Durchkontaktierungen D.

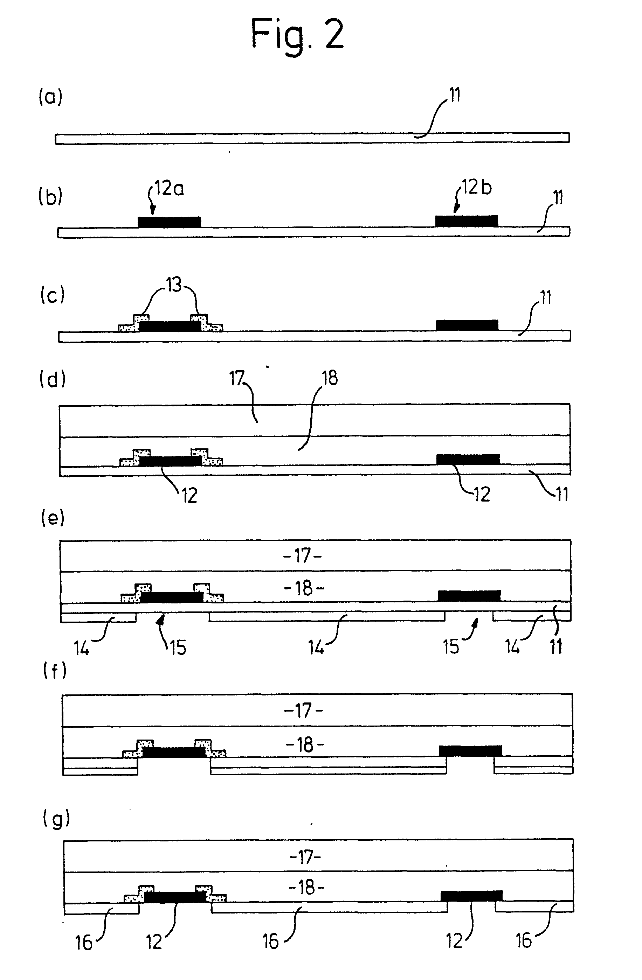

Im Folgenden wird anhand von Fig. 2 (deren Teilfiguren Fig. 2a–2g wiederum verschiedene Stadien im Verlauf des Herstellungsverfahrens der gedruckten Schaltung veranschaulichen) eine abgewandelte Ausführungsform der Erfindung erläutert, bei welcher die Leiterbahnen nicht (unter Verwendung einer Negativ-Abdeckmaske) additiv aufgebaut, sondern subtraktiv (unter Verwendung einer Positivmaske) aus der anfänglichen, vorläufigen metallischen Trägerschicht durch selektive Ätzung erzeugt werden.

Ausgehend von einer (gleichzeitig als vorläufige Trägerplatte dienenden) Kupferfolie 11 (Fig. 2a) werden auf diese wiederum vorzugsweise im Siebdruckverfahren Widerstandspastenbereiche aus einer Widerstandspaste geeigneter spezifischer Leitfähigkeit entsprechend den für die in die Schaltung zu integrierenden Widerständen, Potentiometerbahnen oder Schaltkontaktstellen aufgedruckt; in Fig. 2b sind zwei derartige Widerstandspastenbereiche 12a, 12b dargestellt. Gemäss Fig. 2c können wieder bestimmte dieser Widerstandspastenbereiche an ihren Anschlussenden mit einer überlappenden Silberleitungspaste 13 bedruckt werden, beispielsweise die Potentiometerbahnen an den Schleiferanschlussstellen, wie in Fig. 2c für den Bereich 12a veranschaulicht. Das so erhaltene Gebilde gemäss Fig. 2b bzw. Fig. 2c wird sodann wiederum bei erhöhter Temperatur im Bereich von beispielsweise 200–250 °C ausgehärtet.

In einem anschliessenden Verfahrensschritt gemäss Fig. 2d wird das mit Widerstands-, Potentiometer- bzw. ggf. Kontaktstellen-Bereichen versehene Kupfersubstrat mit seiner mit den mechanisch und elektrisch durch die Aushärtungsbehandlung fixierten Widerstandsbedruckungen 12 versehenen Oberfläche auf eine als dauerhafte Trägerplatte dienende Isolierstoffschicht 17 auflaminiert, und zwar wiederum unter Verwendung eines beispielsweise Epoxydharzklebers 18. Das Auflaminieren des anfänglichen, vorläufigen Metallfolienträgers auf den späteren dauerhaften isolierenden Träger erfolgt bei dieser Ausführungsform somit vor der Ausbildung der Leiterbahnen.

Das so erhaltene Laminat gemäss Fig. 2d wird sodann gemäss Fig. 2e auf seiner Kupferfolienseite 11 (Unterseite in Fig. 2e) mit einer Positivmaske 14 aus einem Ätzresist-Lack versehen, d.h. dass die für die Leiterpfade gewünschten Bereiche durch den Ätzabdeckerlack 14 abgedeckt sind; die Bedruckung mit der Positivmaske 14 kann vorzugsweise im Siebdruckverfahren erfolgen; falls für das Leitungsmuster eine Feinleiterstruktur erforderlich ist, könnten ggf. auch photolithographische Maskierverfahren Anwendung finden.

Nach Trocknung des Ätzmasken- Abdeckerlacks 14 werden nunmehr in an sich bekannter subtraktiver Technik die nicht von dem Ätzresist-Lack abgedeckten Bereiche 15 der Kupferfolie 11 durch selektive Ätzung entfernt, wodurch das erwünschte Leitungsmuster erzeugt wird, vgl. Fig. 2f.

Nach Entfernung des Ätzresist-Abdeckers gemäss Fig. 2g erhält man die fertige gedruckte Schaltung, deren Leitungsmuster 16 aus den stehengebliebenen Bereichen der anfänglichen Kupferschicht 11 besteht und die Widerstände, Potentiometer und ggf. Schaltkontaktstellen integriert enthält. Wegen der bei dieser Ausführung gebildeten Stufen zwischen den Leiterbahnen 16 und den aus den Polymerwiderstandspasten gebildeten Bereichen 12 eignet sich diese Ausführung weniger gut in Fällen, in denen Potentiometerbahnen und insbesondere Kodierschalter in die Schaltung integriert werden sollen, da insbesondere für die Kodierschalter eine stufenlose Oberfläche erforderlich ist.

Die Erfindung wurde vorstehend anhand bevorzugter Ausführungsbeispiele erläutert, die jedoch selbstverständlich in mannigfachen Einzelheiten abgewandelt werden können. So kann die Herstellung der Abdeckmasken je nach der Struktur des Leiterbahnen-Lay-outs im Siebdruckverfahren oder ggf., bei einer Feinstruktur, mittels Lichtdruckverfahren erfolgen. Der additive Aufbau der Leiterbahnen bei der Ausführungsform gemäss Fig. 1 erfolgt vorzugsweise durch galvanische Abscheidung mit einer relativ hohen Abscheidungsgeschwindigkeit; alternativ könnte die Metallabscheidung auch im stromlosen Bade erfolgen.

Bei der obigen Beschreibung der Ausführungsform gemäss Fig. 1 wurden die Kodierschaltersegmente, falls solche in die Schaltung zu integrieren waren, in einem gemeinsamen Verfahrensschritt mit der Erzeugung des Leitungsmusters durch additiven Aufbau metallischer Leiterschichten gebildet; alternativ könnten die Kodierschaltersegmente jedoch auch in dem anfänglichen Verfahrensschritt der Bedruckung mit der Polymerpaste erzeugt werden, wobei sich insbesondere die Verwendung einer entsprechend hoch leitfähigen Pyropolymerpaste für diese Bereiche empfehlen würde, welche im fertigen Erzeugnis an der freiliegenden Oberfläche die erforderliche Oxydationsbeständigkeit und hohe Abriebfestigkeit der betreffenden Segmentbereiche gewährleisten würde.

In den Figuren 1 und 2 wurden der Einfachheit halber jeweils die gedruckten Schaltungen nur auf der einen Seite der als bleibende Trägerplatte dienenden Isolierschicht erzeugt. Nach vorteilhaften Ausgestaltungen können jedoch auf beiden Seiten der Isolierstoffplatte elektrische Schaltungen aufgebaut werden, ggf. auch in Multi-Layer-Ausführung, wobei die Schaltungen der verschiedenen Ebenen bzw. auf den beiden Seiten der Isolierstoffplatte durch Durchkontaktierungen beispielsweise unter Zuhilfenahme chemisch arbeitender Kupferbäder elektrisch-funktionell miteinander verbunden werden können. Eine derartige Ausbildung ist in Fig. 4 veranschaulicht, wo die eine Seite der Isolierstoffplatte 27 (in Fig. 4 die Unterseite) eine beispielsweise gemäss Fig. 1 erzeugte gedruckte Schaltung 28 mit integrierten Widerständen, Potentiometern usw. in einer Epoxydharzeinbettung 29 aufweist, und die andere Seite der Isolierstoffplatte 27 mit einer Multi-Layer-Anordnung 30 aus zwei Epoxydharzschichten 31, 32 versehen ist, die jeweils bei 33 und 34 angedeutete Leitungsmuster enthalten. Die Verbindung zwischen den verschiedenen Ebenen 29, 31, 32 erfolgt durch Kupfer-Durchkontaktierungen 35.

Die integrierten Widerstände, Potentiometer, Schaltkontaktstellen bzw. Kodierschaltersegmente können jeweils durch Bedruckung mit einer einzigen Widerstandspaste geeigneter Leitfähigkeit erzeugt werden, wobei verschiedene Widerstandswerte durch entsprechende geometrische Formgebung realisiert werden können; alternativ können jedoch auch Bedruckungen mit unterschiedlichen Widerstandspasten verschiedener Leitfähigkeit erfolgen, zur Realisierung entsprechender unterschiedlicher Widerstandswerte.

Wesentlich für den Grundgedanken der Erfindung ist die Integration passiver Bauteile wie Widerstände, Potentiometer, Schaltkontaktstellen, Kodierschaltersegmenten in gedruckte Schaltungen, wobei durch Anwendung der beschriebenen Umkehrtechnik die für eine gute elektrische Stabilität der Polymer- Widerstands- bzw. Leitschichten erforderliche Aushärtung bei hoher Aushärttemperatur vor der Umlaminierung auf das elektrisch isolierende Hartpapier-Basismaterial vorgenommen werden kann, wodurch eine Beeinträchtigung des endgültigen Basismaterials und der Haftung der Schaltungsteile an diesem durch die hohe Aushärttemperatur zuverlässig vermieden wird.

**Patentansprüche**

1. Verfahren zur Herstellung gedruckter Schaltungen mit einem elektrisch isolierenden Schaltungsträger, auf dessen Oberfläche elektrisch wirksame Teiloberflächen, bedarfsweise als Leiterbahnen, Widerstandsbahnen oder Kontaktflächen, integriert sind, wobei diese Teiloberflächen aus elektrisch leitende Teilchen enthaltenden Polymerschichten bestehen und durch eine Wärmebehandlung ausgehärtet sind, gekennzeichnet durch die folgenden Verfahrensschritte

– auf einer als vorläufige Trägerschicht dienenden Metallschicht (1, Fig. 1; 11, Fig. 2) werden zunächst die Widerstände, Potentiometerbahnen als Widerstandsschicht, Schaltkontaktstellen oder ggf. Kodierschaltersegmente als Widerstandsschicht oder Leiterschicht (2, Fig. 1; 12, Fig. 2) aus einem elektrisch leitende Teilchen eindispergiert enthaltenden Polymermaterial entsprechender Leitfähigkeit in dem gewünschten Lay-out erzeugt (Figuren 1a–1c; Figuren 2a–2c)

– das mit dem Widerstands-Lay-out (2; 12) versehene Gebilde wird zur Aushärtung des Polymer-Widerstandsmaterials einer Wärmebehandlung unterworfen

– die mit dem Widerstands-Lay-out (2; 12) aus dem Widerstandspolymermaterial und ggf. dem Leitungsmuster versehene Metallschicht (1; 11) wird mit der beschichteten Seite auf eine als permanenter Schaltungsträger dienende Isolierstoffplatte (7; 17) auflaminiert (Fig. 1g; Fig. 2d)

– die als vorläufige Trägerschicht dienende Metallschicht (1; 11) wird abschliessend vollständig oder selektiv abgeätzt (Fig. 1h; Figuren 2e–2g), wobei die Leiterbahnen (6; 16) in Zuordnung zu dem Widerstandsmaterial-Lay-out (2; 12) entweder vor oder nach der Umkehrlaminierung erzeugt werden.

2. Verfahren nach Anspruch 1, dadurch gekennzeichnet, dass die Leiterbahnen (6, Fig. 1) und ggf. die Kodierschaltersegmente auf der mit dem Widerstandsmaterial-Lay-out (2, Fig. 1) versehenen Oberfläche der Metallschicht (1) vor der Umkehr-Laminierung unter Verwendung einer Negativ-Abdeckmaskierung (4) additiv aufgebaut werden (Figuren 1d, 1e), und dass die Metallschicht (1) im abschliessenden Verfahrensschritt nach der Umkehrlaminierung vollständig entfernt wird.

3. Verfahren nach Anspruch 1, dadurch gekennzeichnet, dass der additive Aufbau der Leiterbahnen (6, Fig. 1) und ggf. der Kodierschaltersegmente durch galvanische Abscheidung einer oder mehrerer Metallschichten (6a, 6b, Fig. 1e) unter Verwendung einer Negativ-Abdeckung aus einem Galvano-Resist-Lack (4) erfolgt.

4. Verfahren nach Anspruch 2 oder 3, dadurch gekennzeichnet, dass in den nicht-abgedeckten, freiliegenden Bereichen (5) der Negativ-Abdeckmaskierung (4) jeweils aufeinanderfolgend mehrere Metallschichten zum Aufbau der Leiterbahnen abgeschieden werden, gemäss einer der folgenden Kombinationen: Goldschicht, darüberliegende Nickelschicht, darüberliegende Kupferschicht; Zinnschicht und darüberliegende Kupferschicht; Blei/Zinn-Legierungsschicht und darüberliegende Kupferschicht.

5. Verfahren nach einem oder mehreren der Ansprüche 2–4, dadurch gekennzeichnet, dass die Negativ-Abdeckmaskierung, insbesondere der Galvano-Resist-Lack (4), vor der Aushärt-Wärmebehandlung aufgebracht und zusammen mit dem Widerstandsmaterial-Lay-out (2) ausgehärtet wird.

6. Verfahren nach einem oder mehreren der Ansprüche 2–5, dadurch gekennzeichnet, dass die Negativ-Abdeckmaskierung, insbesondere aus dem Galvano-Resist-Lack (4), durch selektive UV-Bestrahlung ausgehärtet wird.

7. Verfahren nach einem oder mehreren der Ansprüche 2–6, dadurch gekennzeichnet, dass die Kodierschaltersegmentbereiche im ersten Verfahrensschritt gemeinsam mit der Aufbringung des Widerstandsschicht-Lay-outs unter Verwendung eines Polymer-Widerstandsmaterials hoher Leitfähigkeit erzeugt werden.

8. Verfahren nach einem oder mehreren der Ansprüche 2–7, dadurch gekennzeichnet, dass die als vorläufige Trägerschicht dienende Metallschicht (1, Fig. 1) aus Stahl oder Aluminium oder Kupfer oder deren Legierungen besteht.

9. Verfahren nach Anspruch 1, dadurch gekennzeichnet, dass die als vorläufige Trägerschicht dienende Metallschicht (11, Fig. 2) aus einem elektrisch gut leitenden Metall, insbesondere aus Kupfer besteht, und dass die Leiterbahnen (16, Fig. 2) nach der Umkehrlaminierung als abschliessender Verfahrensschritt unter Verwendung einer Positiv-Abdeckmaskierung (14) in subtraktiver Technik aus der anfänglichen Metallschicht (11) durch selektive Ätzung erzeugt werden. (Figuren 2e–2g)

10. Verfahren nach einem oder mehreren der vorhergehenden Ansprüche, dadurch gekennzeichnet, dass das Widerstands-Lay-out (2; 12) unter Verwendung einer Widerstands- bzw. Leitfähigkeitspaste aufgebracht wird, welche aus einem organischen Polymer-Bindemittel mit in diesem eindispergierten elektrisch leitenden Teilchen aus einem Material der Gruppe: Russ, Graphit, Pyropolymer, Gold, Silber, Nickel oder versilberte Kupferteilchen mit einer Korngrösse von kleiner als 10 μ besteht.

11. Verfahren nach einem oder mehreren der vorhergehenden Ansprüche, insbesondere nach Anspruch 10, dadurch gekennzeichnet, dass die Widerstands- bzw. Polymer-Leitfähigkeitspaste im Siebdruck- oder Spritzverfahren aufgebracht wird.

12. Verfahren nach einem oder mehreren der vorhergehenden Ansprüche, dadurch gekennzeichnet, dass die Abdeckmaskierung in dem für das Leitungsmuster und ggf. die Kodierschaltersegmente gewünschten Lay-out im Siebdruckverfahren aufgedruckt wird.

13. Verfahren nach einem oder mehreren der vorhergehenden Ansprüche 1–11, insbesondere zur Anwendung bei Feinleiterstruktur des Leiterbahnen-Lay-outs, dadurch gekennzeichnet, dass die Abdeckmaskierung unter Anwendung photolithographischer Verfahren erzeugt wird.

14. Verfahren nach einem oder mehreren der vorhergehenden Ansprüche, dadurch gekennzeichnet, dass die Umkehr-Laminierung der die Schaltung bzw. Schaltungsteile tragenden Metallschicht (1; 11) auf den permanenten Isolierstoff-Schaltungsträger (7; 17) unter Verwendung eines Harzklebers, vorzugsweise Epoxidharzklebers (8; 18), erfolgt.

15. Verfahren nach einem oder mehreren der vorhergehenden Ansprüche, dadurch gekennzeichnet, dass als permanenter Schaltungsträger eine Isolierstoffplatte (7; 17) aus einem Hartpapiermaterial, einem faserverstärkten Schichtpressstoff oder einer Kunststoff-Folie verwendet wird.

16. Verfahren nach einem oder mehreren der vorhergehenden Ansprüche, dadurch gekennzeichnet, dass die Wärmebehandlung zur Aushärtung der Widerstands- bzw. Leitfähigkeitspolymer-Schicht (2; 12) bei einer Temperatur im Bereich von 180–250 °C erfolgt.

17. Verfahren nach einem oder mehreren der vorhergehenden Ansprüche, dadurch gekennzeichnet, dass auf beiden Seiten der als permanenter Träger dienenden Isolierstoffplatte (27, Fig. 4) gedruckte Schaltungen (29, 30) aufgebaut werden und die Schaltungen durch mittels chemisch arbeitender Kupferbäder erzeugte Durchkontaktierungen (35, Fig. 4) elektrisch miteinander verbunden werden.

18. Verfahren nach einem oder mehreren der vorhergehenden Ansprüche, dadurch gekennzeichnet, dass die Schaltung auf der einen oder auf beiden Seiten der als permanenter Träger dienenden Isolierstoffplatte (27) als Multi-Layer-Anordnung (30, 31, 32, Fig. 4) ausgebildet und die verschiedenen Schaltungsebenen der Multi-Layer-Anordnung durch mittels chemisch arbeitender Kupferbäder erzeugte Durchkontaktierungen (35) miteinander verbunden werden.

## Claims

1. Process for the production of printed circuits having an electrically insulating circuit carrier, on the surface of which electrically operative surface portions are integrated, being conductor strips, resistance strips or contact surfaces as required, wherein these surface portions comprise polymer layers containing electrically conductive particles and are hardened by a heat treatment, characterised by the following process steps
– on a metal layer (1, Fig. 1; 11, Fig. 2) used as a temporary carrier layer there are produced first of all in the desired lay-out (Figures 1a–1c; Figures 2a–c) the resistances, potentiometer strips in the form of a resistance layer, switch contact points or, if need be, coding switch segments in the form of a resistance layer or a conductor layer (2, Fig. 1; 12, Fig. 2) of a polymer material of appropriate conductivity containing dispersed electrically conductive particles
– the structure provided with the resistance lay-out (2; 12) is subjected to heat treatment to harden the polymer resistance material
– the metal layer (1; 11) provided with the resistance lay-out (2; 12) of the resistance polymer material and, if need be, the conductive pattern is laminated with the coated side onto an insulating material board (7; 17) used as a permanent circuit carrier (Fig. 1g; Fig. 2d)
– the metal layer (1; 11) used as a temporary carrier layer is finally completely or selectively etched (Fig. 1h; Figures 2e–g), whereby the conductor strips (6; 16) are produced in association with the resistance material lay-out (2; 12), either before or after the reverse lamination.

2. Process according to claim 1, characterised in that the conductor strips (6, Fig. 1) and, if need be, the coding switch segments are additively built-up on the surface of the metal layer (1) provided with the resistance material lay-out (2, Fig. 1) before the reverse lamination using negative-diffusion masking (4) (Figures 1d, 1e), and in that the metal layer (1) is completely removed in the final process step after the reverse lamination.

3. Process according to claim 1, characterised in that the additive build-up of the conductor strips (6, Fig. 1) and, if need be, the coding switch segments is effected by electro-separation of one or more metal layers (6a, 6b, Fig. 1e) using a negative masking of an electro-resist enamel (4).

4. Process according to claim 2 or 3, characterised in that in the unmasked freely exposed areas (5) of the negative diffusion masking (4) several metal layers are respectively separated one after the other to build-up the conductor strips, according to one of the following combinations: gold layer, superimposed nickel layer, superimposed copper layer; tin layer and superimposed copper layer; lead/tin alloy layer and superimposed copper layer.

5. Process according to one or more of claims 2–4, characterised in that the negative diffusion masking, in particular the electro-resist enamel (4), is applied before the hardening heat treatment and is hardened together with the resistance material lay-out (2).

6. Process according to one or more of claims 2–5, characterised in that the negative-diffusion masking, in particular from the electro-resist enamel (4), is hardened by selective UV radiation.

7. Process according to one or more of claims 2–6, characterised in that the coding switch segment areas are produced in the first process step together with the application of the resistance layer lay-out using a polymer resistance material of high conductivity.

8. Process according to one or more of claims 2–7, characterised in that the metal layer (1, Fig. 1) used as a temporary carrier layer (1, Fig. 1) is composed of steel or aluminium or copper, or their alloys.

9. Process according to claim 1, characterised in that the metal layer (11, Fig. 2) used as a temporary carrier layer comprises a good electrically conductive metal, in particular copper, and in that the conductor strips (16, Fig. 2) are produced by selective etching after the reverse lamination as a final process step using a positive diffusion masking (14) by the subtractive technique from the initial metal layer (11) (Figures 2e–2g).

10. Process according to one or more of the preceding claims, characterised in that the resistance lay-out (2; 12) is applied using a resistance paste or a conductivity paste which comprises an organic polymer bonding agent having dispersed in it electrically conductive particles of a material of the group: carbon black, graphite, pyropolymer, gold, silver, nickel or silver-plated copper particles with a grain size of less than 10 µ.

11. Process according to one or more of the preceding claims, in particular according to claim 10, characterised in that the resistance paste or polymer conductivity paste is applied by the screen printing or injection moulding method.

12. Process according to one or more of the preceding claims, characterised in that the diffusion masking is printed by the screen printing method in the lay-out desired for the conductive pattern and, if need be, the coding switch segments.

13. Process according to one or more of the preceding claims 1–11, in particular for use in a fine conductor structure of the conductor strips lay-out, characterised in that the diffusion masking is produced using the photolithographic process.

14. Process according to one or more of the preceding claims, characterised in that the reverse lamination of the metal layer (1; 11) carrying the circuit or circuit parts is effected onto the permanent insulating material circuit carrier (7; 17) using a resinous bonding agent, preferably an epoxide resin bonding agent (8; 18).

15. Process according to one or more of the preceding claims, characterised in that as a permanent circuit carrier there is used an insulating material board (7; 17) of a hard paper material, a fibre-reinforced moulded laminated plastic or a plastics foil.

16. Process according to one or more of the preceding claims, characterised in that the heat treatment for hardening the resistance layer or conductivity polymer layer (2; 12) is carried out at a temperature in the range of 180–250 °C.

17. Process according to one or more of the preceding claims, characterised in that on both sides of the insulating material board (27, Fig. 4) used as a permanent carrier, printed circuits (29, 30) are assembled and the circuits are electrically connected to each other by means of through-connections (35, Fig. 4) produced by means of chemically acting copper baths.

18. Process according to one or more of the preceding claims, characterised in that the circuit is assembled as a multi-layer arrangement (30, 31, 32, Fig. 4) on one or on both sides of the insulating material board (27), used as the permanent carrier, and the different circuit planes of the multilayer arrangement are joined together by means of through-connections (35) produced by means of chemically acting copper baths.

## Revendications

1. Procédé de fabrication de circuits imprimés présentant un substrat de circuit électriquement isolant, à la surface duquel des régions superficielles partielles électriquement efficaces, sont intégrées, si besoin est sous la forme de pistes conductrices, de pistes résistives ou de surfaces de contact, ces régions superficielles partielles consistant en des couches de polymère qui renferment des particules électriquement conductrices, et étant durcies par un traitement thermique, procédé caractérisé par les étapes opératoires suivantes

– tout d'abord, sur une couche métallique (1, figure 1; 11, figure 2) servant de couche de substrat provisoire, les résistances et les pistes potentiométriques sont produites en tant que couche résistive, les zones de contact de commutation ou éventuellement les segments commutateurs de codage sont produits en tant que couche résistive ou couche conductrice(2, figure 1; 12, figure 2), à partir d'un matériau polymère de conductivité correspondante qui renferme des particules électriquement conductrices incorporées par dispersion, et selon l'agencement souhaité (figures 1a–1c; figures 2a–2c)

– la structure munie de l'agencement résistif (2; 12) est soumise à un traitement thermique en vue du durcissement du matériau résistif polymère

– la couche métallique (1; 11), munie de l'agencement résistif (2; 12) provenant du matériau polymère résistif, et éventuellement du réseau de conducteurs, est appliquée, par sa face revêtue, en stratification sur une plaque en matériau isolant (7; 17) servant de substrat permanent au circuit (figure 1g; figure 2d)

– la couche métallique (1; 11) servant de couche de substrat provisoire est, pour finir, décapée intégralement ou sélectivement (figure 1h; figures 2e–2g), les pistes conductrices (6; 16) étant alors produites d'une manière correspondant à l'agencement du matériau résistif (2; 12), soit avant, soit après le transfert de stratifié.

2. Procédé selon la revendication 1, caractérisé par le fait que les pistes conductrices (6, figure 1) et éventuellement les segments commutateurs de codage sont produits en mode additif (figures 1d, 1e) avant le transfert de stratifié, en utilisant un masque de recouvrement négatif (4), sur la surface de la couche métallique (1) dotée de l'agencement du matériau résistif (2, figure 1); et par le fait que, lors de l'étape opératoire finale, la couche métallique (1) est totalement éliminée après le transfert de stratifié.

3. Procédé selon la revendication 1, caractérisé par le fait que la formation en mode additif des pistes conductrices (6, figure 1) et éventuellement des segments commutateurs de codage a lieu par dépôt galvanique d'une ou de plusieurs couches métalliques (6a, 6b, figure 1e), en utilisant un recouvrement négatif en un vernis galvanorésistant (4).

4. Procédé selon la revendication 2 ou 3, caractérisé par le fait que, dans les zones (5) dégagées et non recouvertes du masque de recouvrement négatif (4), plusieurs couches métalliques respectivement successives sont déposées en vue de former les pistes conductrices, selon l'une des combinaisons suivantes: couche d'or, couche de nickel sus-jacente, couche de cuivre sus-jacente; couche d'étain et couche de cuivre sus-jacente; couche en alliage plomb-étain et couche de cuivre sus-jacente.

5. Procédé selon l'une ou plusieurs des revendications 2–4, caractérisé par le fait que le masque de recouvrement négatif, en particulier le vernis galvanorésistant (4) est appliqué préalablement au traitement thermique de durcissement, et est durci conjointement à l'agencement en matériau résistif (2).

6. Procédé selon l'une ou plusieurs des revendications 2–5, caractérisé par le fait que le masque de recouvrement négatif, constitué notamment par le vernis galvanorésistant (4), est durci par irradiation UV sélective.

7. Procédé selon l'une ou plusieurs des revendications 2–6, caractérisé par le fait que, lors de la première étape opératoire, les régions des segments commutateurs de codage sont engendrées concomitamment au dépôt de l'agencement des couches résistives, en utilisant un matériau résistif polymère de grande conductivité.

8. Procédé selon l'une ou plusieurs des revendications 2–7, caractérisé par le fait que la couche métallique (1, figure 1) servant de couche de substrat provisoire consiste en de l'acier, en de l'aluminium, en du cuivre ou en des alliages de ces derniers.

9. Procédé selon la revendication 1, caractérisé par le fait que la couche métallique (11, figure 2), servant de couche de substrat provisoire, consiste en un métal de bonne conductivité électrique, en particulier du cuivre; et par le fait que, en tant qu'étape opératoire finale, les pistes conductrices (16, figure 2) sont produites par décapage sélectif à partir de la couche métallique initiale (11) après le transfert du stratifié inversé, en utilisant un masque de recouvrement positif (14) et en appliquant la technique soustractive (figures 2e–2g).

10. Procédé selon l'une ou plusieurs des revendications précédentes, caractérisé par le fait que, l'agencement résistif (2; 12) est déposé en utilisant une pâte respectivement résistive ou conductrice qui se compose d'un liant polymère organique dans lequel sont incorporées, par dispersion, des particules électriquement conductrices d'un matériau du groupe renfermant le noir de carbone, le graphite, un pyropolymère, l'or, l'argent, le nickel ou des particules de cuivre argentées, présentant une granulométrie inférieure à 10 μ.

11. Procédé selon l'une ou plusieurs des revendications précédentes, en particulier la revendication 10, caractérisé par le fait que la pâte respectivement résistive ou en un polymère conducteur est déposée par sérigraphie ou par projection par pulvérisation.

12. Procédé selon l'une ou plusieurs des revendications précédentes, caractérisé par le fait que le masque de recouvrement est imprimé par sérigraphie selon l'agencement souhaité pour le réseau de conducteurs, et éventuellement pour les segments commutateurs de codage.

13. Procédé selon l'une ou plusieurs des revendications précédentes 1 à 11, destiné en particulier à être appliqué lorsque l'agencement des pistes conductrices présente une structure conductrice fine, caractérisé par le fait que le masque de recouvrement est engendré en appliquant des procédés photolithographiques.

14. Procédé selon l'une ou plusieurs des revendications précédentes, caractérisé par le fait que le transfert de stratifié inversé, sur le substrat permanent de circuit en matériau isolant (7; 17), de la couche métallique (1; 11) portant respectivement le circuit ou des parties de ce circuit, a lieu en utilisant un adhésif à base de résine, de préférence un adhésif (8; 18) à base de résine époxyde.

15. Procédé selon l'une ou plusieurs des revendications précédentes, caractérisé par le fait qu'on utilise, en tant que substrat permanent du circuit, une plaque en matériau isolant (7; 17) consistant en une matière du type papier dur, en une matière stratifiée comprimée renforcée par des fibres ou en une feuille de matière plastique.

16. Procédé selon l'une ou plusieurs des revendications précédentes, caractérisé par le fait que le traitement thermique destiné au durcissement de la couche (2; 12) respectivement résistive ou en un polymère conducteur a lieu à une température située dans la plage de 180 à 250 °C.

17. Procédé selon l'une ou plusieurs des revendications précédentes, caractérisé par le fait que des circuits imprimés (29, 30) sont implantés des deux côtés de la plaque en matériau isolant (27, figure 4) servant de substrat permanent, ces circuits étant reliés électriquement les uns aux autres par l'intermédiaire de métallisations (35, figure 4) engendrées au moyen de bains de cuivre travaillant chimiquement.

18. Procédé selon l'une ou plusieurs des revendications précédentes, caractérisé par le fait que le circuit situé sur l'un ou sur les deux côtés de la plaque en matériau isolant (27) servant de substrat permanent est réalisé sous la forme d'un agencement multicouches (30, 31, 32, figure 4), les différents plans de commutation de cet agencement multicouches étant reliés les uns aux autres par l'intermédiaire de métallisations (35) produites au moyen de bains de cuivre travaillant chimiquement.

0 073 904

# Fig. 1

(a) 1

(b) 2a 2b

(c) 3 2a 3

(d) 4 5 4 5 4 5 4 5 4 5

(e) 6 6 6 6 6b 6a
6b 6a

(f) 6 6 6
2 2 1

(g) 8 7
8

(h)
-7-
-8-
6 3 2 3 6 6 2 6

11

# Fig. 2

(a)

11

(b)

12a    12b    11

(c)

13    11

(d)

17    18

12    12    11

(e)

-17-

-18-

14    15    14    15    14    11

(f)

-17-

-18-

(g)

-17-

-18-

16    12    16    12    16

# Fig. 3

# Fig. 4